# EUROPEAN PATENT APPLICATION

(11) **EP 4 718 156 A1**
(43) Date of publication of application: **01.04.2026**
(21) Application number: 24203228.2
(22) Date of filing: 27.09.2024
(51) Int. Cl.: G03F 7/00, H01L 21/677

(54) **SEMICONDUCTOR FABRICATION TOOL, LOAD PORT FOR AND METHOD OF OPERATING SUCH A TOOL**

(71) Applicant: Brooks Automation (Germany) GmbH, 78256 Steißlingen (DE)
(72) Inventor: Schwetz, Michael, 8400 Winterthur (CH); Fenner, Yves, 8572 Berg (CH)
(74) Representative: Dehns Germany Partnerschaft mbB

(57) **Abstract**

The invention provides a semiconductor fabrication tool, particularly a stocker, (100) for processing a semiconductor fabrication article, particularly a reticle, the tool comprising at least one load port (151, 152, 153, 154), an article handler (112, 114), and an article processing unit (120), wherein the load port (151, 152, 153, 154) is configured to accept, from outside the tool (100), a transport container (200) holding the article, to open the transport container (200), and to provide the article handler (112, 114) with access to the article within the transport container (200), wherein the article processing unit (120) is configured to process a predetermined number of articles, wherein processing an article particularly comprises storing the article in a respective storage position, wherein the article handler (112, 114) is configured to retrieve an article from the article processing unit (120) and/or to retrieve the article from the opened transport container (200) and to transfer the article between the transport container (200) and the article processing unit (120), the tool (100) further comprising a container storage unit (220) and a container handler (212) for transferring the transport container (200) between the container storage unit (220) and the load port (151, 152, 153, 154). Further, a load port (151, 152, 153, 154) for such a tool (100) and a method for operating such a tool (100) are provided.

## Description

The present invention relates to a stocker for semiconductor fabrication articles (for example reticles) and a method of operating said stocker.

### Background

Photolithography processes are widely used as one of the key steps in the manufacture of integrated circuits (ICs) and other semiconductor-related devices and/or structures. However, as the dimensions of features produced by such processes decrease, the importance of photolithography for the production of miniature ICs or other devices and/or structures rises.

In photolithography, a geometric pattern is transferred from a photomask (typically referred to as reticle) onto a substrate, for example a semiconductor wafer, by the use of light, a photosensitive layer and a subsequent etching step. Depending on the desired feature size on the substrate, the feature size of the reticle needs to be adapted as well as the wavelength of the light used for pattern transfer, with consideration of the Raleigh criterion.

In order to reduce the smallest achievable feature size, it has been proposed to use extreme ultraviolet (EUV) radiation. EUV radiation is electromagnetic radiation having a wavelength within the range of 5-20 nm, for example within the range of 5-10 nm.

Any contamination of the reticle may reduce the imaging performance of the photolithographic process and may in more serious cases require the reticle to be replaced. The reticle is typically expensive and therefore any reduction in the frequency with which it must be replaced is advantageous. Furthermore, replacement of the reticle is a time-consuming process, during which the photolithographic process may have to be supported, thereby reducing its efficiency, which is undesirable.

For EUV applications, particle contamination with particle sizes of less than 10 nm as well as chemical contamination, for example by adsorption of volatile organic compounds, can be relevant.

The reticles used for such EUV applications are therefore typically stored in a storage stocker, and retrieved when needed in connection with the lithography exposure equipment. Usually, the reticles are contained in a double shell container (double pod) comprising a so-called EUV outer pod (EOP) and an EUV inner pod (EIP).

Such a double pod is described in further detail in US 2019/0214287 A1, for example.

Reticles (as well as other articles, for example raw or processed semiconductor substrates or partially or completely produced ICs) may be stored within encasements or carriers, such as the mentioned double pods, (e.g. in so-called carrier stockers) or without such encasements or carriers (e.g. in so-called bare stockers or semi-bare stockers). This is independent of the specific wavelength used in the lithography process. For example, DUV-processes may also be used.

A reticle stocker capable of storing bare reticles and pods, or any other tool for handling semiconductor fabrication articles and storing the respective transport containers during such handling, so-called internal buffer tools, require load ports to load pods or other transport containers into the tool and (SMIF) openers for extracting the respective articles from the transport containers. The load ports for the respective transport containers must typically be aligned at the front side of the tool, e.g. along an OHT track, for automatic transfers and/or for manual transfers by operators. The SMIF openers are conventionally embedded into the tool between an internal container handling and/or storage area and an internal article handling and/or storage area. The SMIF openers are normally not externally accessible, i.e. they are only interfaced with other devices of the tool, but do not have an interface to the outside of the tool.

A handling sequence for loading and unloading of articles into/from their respective dedicated containers in such traditional internal buffer tools therefore requires at least two internal container moves (direct moves from load port to SMIF opener to internal buffer or back to load port) or three container moves with previous buffering. This causes a lower throughput compared to fixed buffer tools and pod stockers, e.g. stockers in which reticles are stored inside a double pod as previously described.

### Disclosure of the invention

The present invention relates to a load port for a tool (e.g. a stocker, a lithography tool, an inspection tool, a cleaning tool or the like) for handling semiconductor fabrication articles (for example reticles), a semiconductor fabrication tool, particulary a stocker, with such a load port and a method of operating said tool as set out in the respective independent claims. The invention particularly pertains to stockers for storing articles without a transport container, such as an outer pod or EOP in the case of EUV-reticles, to provide higher storage density. According to embodiments of the invention, a number of transport containers (e.g. outer pods or EOPs, or DUV-pods such as an RSP150 or an RSP200, as defined in SEMI standard E19-0417, for example) are storable within a container storage portion of the stocker.

In detail, a load port for interfacing an interior of a semiconductor fabrication tool, particularly a stocker for storing a semiconductor fabrication article, particularly a reticle, with an exterior of the tool according to the present invention comprises an external interface configured to accept from and/or deliver to the exterior of the tool a transport container configured to hold at least one article, a first internal interface configured to allow access to an internal volume of the transport container from the interior of the tool, and a second internal interface configured to accept from and/or deliver to the interior of the tool the transport container, wherein the load port is configured to open and/or close the transport container.

The semiconductor fabrication tool, particularly a stocker, according to the invention comprises at least one load port according to the invention, an article handler, and an article processing unit, particularly an article storage unit. The load port is configured to provide the article handler with access to the internal volume of the transport container via the first internal interface. The article processing unit is configured to process, for example store or clean, a predetermined number of articles, for example, in respective storage positions. The article handler is configured to retrieve an article from the article processing unit and/or to retrieve the article from the opened transport container and to transfer the article between the transport container and the article processing unit. The stocker according to the invention further comprises a container handler and a container storage portion, wherein the container handler is configured to transfer a container between the load port and the container storage unit via the second internal interface of the load port. In other words, the at least one load port is also configured to accept a transport container from within the container storage unit via the second internal interface. Thereby, the tool is also configured to store a number of (for example empty) transport containers and to retrieve those stored transport containers in order to prepare stored or otherwise processed articles for pick-up. Additionally, this container storage functionality may also be used as an intermediate buffer storage for articles enclosed in transport containers during operating times with a high throughput, such that unloading of articles to be processed in the article processing unit may be postponed until the at least one load port is less busy. This increases the overall throughput and maximises availability of the tool.

In other words, the load port according to the invention performs not only the functions for which it is traditionally used, i.e. transferring the container with the article from outside the tool to an inner volume of the tool, but also functions which are traditionally performed by an additional device, for example a so-called SMIF (standard mechanical interface) opener, typically used for opening transport containers and loading and/or unloading articles to/from the opened transport container. By combining these functionalities in the load port, handling time can be drastically reduced, since fewer container movements are required in order to retrieve an article from a transport container or to place an article into a transport container. Furthermore, investment and spatial footprint normally required for the mentioned additional devices may be saved.

In at least one embodiment, the article storage unit (when the tool is a stocker) and/or the container storage unit, may comprise a motorized storage unit, particularly a rotatable storage carousel, with a plurality of storage positions for storing articles and/or transport containers, respectively.

Irrespective of the specific designs of the article processing unit and the container storage unit, the article processing unit and the container storage unit may be positioned vertically directly adjacent to one another. In other words, the article processing unit may be positioned directly on top of the container storage unit or vice versa. This is particularly advantageous, as it enables the load port to require substantially only a vertical axis of movement, with the first and second internal interfaces being substantially aligned vertically above one another.

In at least one embodiment, in which the tool is a stocker, the stocker comprises at least two article handlers each configured to access the storage positions within the article storage unit and to place an article therein for storage or to retrieve an article therefrom, wherein the at least two article handlers are arranged at different positions with respect to the article storage unit and are configured to access storage positions within the article storage unit substantially independently from one another.

Alternatively or additionally, the stocker may comprise at least two container handlers each configured to access the storage positions within the container storage unit and to place a transport container therein for storage or to retrieve a transport container therefrom, wherein the at least two container handlers are arranged at different positions with respect to the container storage unit and are configured to access storage positions within the container storage unit substantially independently from one another.

By providing at least two substantially independent article and/or container handlers, respectively, the throughput (or mean amount of handling operations per time unit) can be increased significantly, as each handler can access a storage position while another one of the at least two handlers is still busy with another handling operation. Furthermore, in case of a malfunction of one respective handler, another one of the at least two respective handlers may still be used, thereby increasing the availability of the stocker (in that case with accordingly reduced throughput).

According to at least one embodiment, the article storage unit and/or the container storage unit comprises a motorized storage unit, particularly a rotatable storage carousel, with a plurality of storage positions for articles or transport containers, respectively, wherein the plurality of storage positions is distributed among at least two, three, four, five or more storage portions, wherein each one of the storage portions comprises a motor configured to displace the respective storage portion substantially independently from any of the remaining storage portions. In case of a storage carousel, the storage portions may be configured as coaxially arranged axial storage portions stacked one above the other. This independent displaceability (further) increases throughput since respective handlers may access a storage position, while another storage position may be displaced within the reach of the handler for subsequent access at the same time, as long as those storage positions are associated with different storage portions. Furthermore, in case of a malfunction of a motor of one of the storage portions, the remaining storage portions remain accessible, thereby (further) increasing the availability of the stocker and/or stored articles. This embodiment, i.e. independently displaceable storage portions, can be combined with the previously discussed embodiment featuring redundant (article and/or container) handlers, to synergistically enhance the advantageous effects of both variants.

In at least one variant of the previously mentioned embodiment, two or more neighbouring storage portions are mechanically couplable with one another such that two or more coupled storage portions can be simultaneously displaced by means of the motor of one of the coupled storage portions, particularly in a case in which a motor of at least one of the storage portions is not functional. This further increases the availability of the stocker and the articles and/or transport containers stored therein, because all the storage positions remain accessible with this arrangement.

In embodiments with more than one article or container handler, each of the at least two respective handlers is associated with at least one respective load port. As explained above, a load port is an interface unit connecting the stocker with peripheral equipment, such as a transport system. The load ports are configured to receive an article enclosed within a transport container (also called an encasement or carrier) from outside the stocker and to optionally open the transport container and/or to retrieve the article from within the transport container. Furthermore, the load port may be configured to purge an atmosphere within and/or surrounding the transport container. Furthermore, the load ports are also configured to perform those operations reversely in order to provide an article from within the stocker to the peripheral equipment outside the stocker. Each of the at least one load ports may be accessible by each of the at least two respective handlers, or some or all of the at least one load ports may be exclusively associated with a single one of the at least two respective handlers, such that only the handler associated with the respective load port may access the load port. In some embodiments, each load port is associated with only a single one (of each) of the at least two (article and/or container) handlers, respectively. This facilitates the operation of the handlers, as no check needs to be conducted, if a specific load port is in use by another of the at least two handlers.

Typically, reticles are stored with an encasement, for example in a double pod as described above. This conventional solution provides for quick access to reticles, since packing into transport containers is not required, when they are already stored within such transport containers, e.g. double pods or in an RSP150 or RSP200. However, due to the better storage conditions and density mentioned, it may be beneficial to store even such vulnerable articles as reticles in a bare stocker, i.e. without encasement, or semi-bare stocker, i.e. several reticles together in a common box or a single reticle in a custom encasement, i.e. a special pod optimized only for storage. The stocker provided by embodiments of this invention alleviates the longer access time by providing at least two article handlers, such that even for critical articles such as reticles, such a bare or semi-bare stocker may be used. The load port according to the invention also provides for shorter handling times as compared to conventional solutions.

According to the present invention, a method of operating a semiconductor fabrication tool according to the invention, comprises accepting, at an outside interface of the load port, a transport container, controlling the load port to open the container and to provide the at least one article handler with access to an inner volume of the transport container, controlling the article handler to retrieve an article from the transport container and/or to place an article into the transport container and controlling the load port to close the transport container. This method profits from the advantages of the tool according to the invention in a corresponding manner.

According to at least one embodiment, in a case in which the tool is a stocker and comprises at least two article handlers the method comprises controlling a first one of the at least two article handlers to perform a first handling operation regarding a first article, the first handling operation requiring access to a first storage position of the article storage unit of the stocker and controlling a second one of the at least two article handlers to perform a second handling operation regarding a second article, the second handling operation requiring access to a second storage position within the article storage unit. Particularly the second handling operation may be performed during a time in which the first article handler is performing at least a part of the first handling operation. The second storage position can be different from the first storage position. This method, similarly to the above described aspect relating to the stocker, increases throughput and availability for the same reasons as set out herein above. The same advantages are also realised with respect to container handling efficiency when more than one container handler is used.

In at least one embodiment, in case the tool (particularly in the form of a stocker) is equipped with a motorized storage unit (for articles and/or transport containers), the method further comprises controlling the motorized storage unit to move the storage position to be accessed within a reach of the respective handler. If the motorized storage unit comprises more than one storage portions, this operation may also be performed for several storage positions to be accessed at the same time, provided the respective storage positions are located in different storage portions. This reduces the required movement of the respective handler and, therefore, further increases operation speed and throughput and makes it possible to use simpler article and/or container handlers, since less freedom of movement is required for accessing the respective storage positions as compared to a stationary storage unit. This is viable in a case in which the tool comprises a single article and/or container handler as well as a case with more than one handlers and a storage unit with two or more motorized storage portions. In such a case, a second storage portion can already move the storage position required for a subsequent (i.e. "second") handling operation while one respective handler is still busy with the current task (i.e. the "first" handling operation).

In a case, in which the article storage unit and/or the container storage unit comprise at least two, three, four, five or more storage portions, wherein each one of the storage portions is displaceable independently from any of the remaining storage portions by a respective motor, the method further comprises identifying the storage portions in which the first and second storage positions are located, respectively; controlling the respective motor of the identified storage portions to move the first and second storage positions within the reach of the at least one or the first and second article and/or container handlers, respectively; determining if the displacement of the identified storage portions was effected as controlled, and, in case at least one storage portion was not displaced as controlled, coupling the respective storage portion with a neighbouring storage portion and controlling the motor of the neighbouring storage portion to move the first and second storage position within the reach of the first or second article and/or container handler, respectively. This, as already described above in relation to the respective embodiment of the tool, improves the availability of processed articles and the tool as such.

Brief description of the appended drawings
Figure 1 schematically depicts an embodiment of a semiconductor fabrication tool in the form of a stocker according to the present invention in a top view.
Figure 2 schematically depicts the stocker of Fig. 1 in a partial side view, with a focus on an area, in which articles are stored.
Figure 3 schematically depicts the stocker of Fig. 1 in a side view, which is less detailed in comparison to Fig. 2 but also showing an area, in which containers for said articles are stored.
Figure 4 schematically depicts a load port for a stocker according to the invention.

### Detailed description

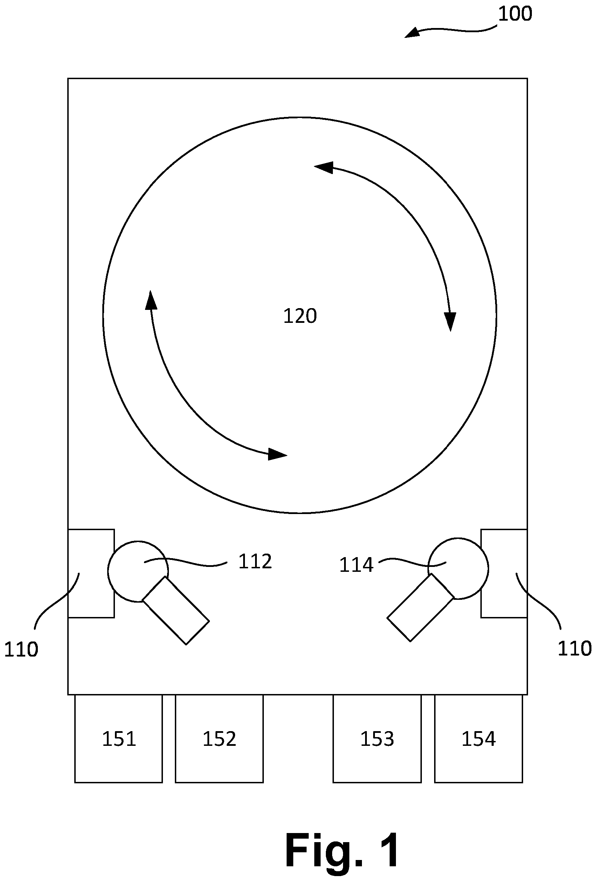

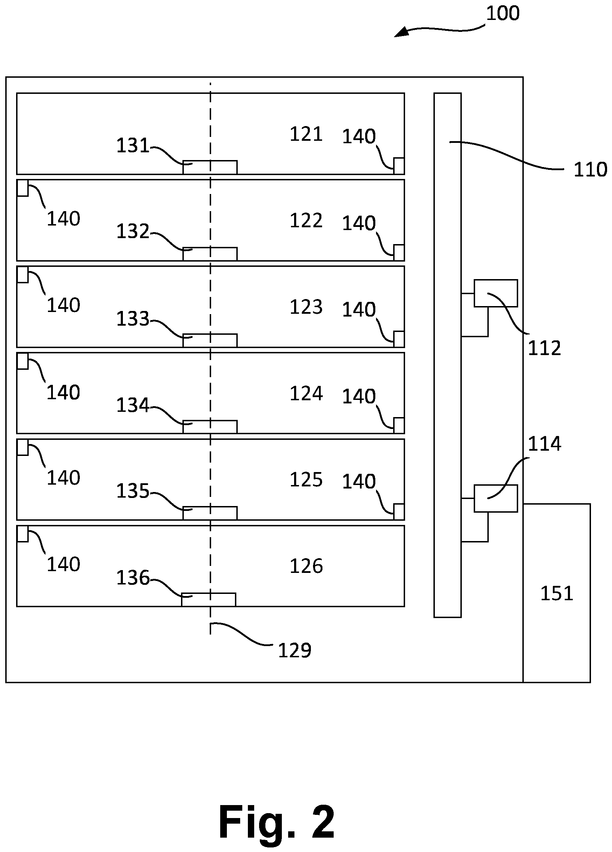

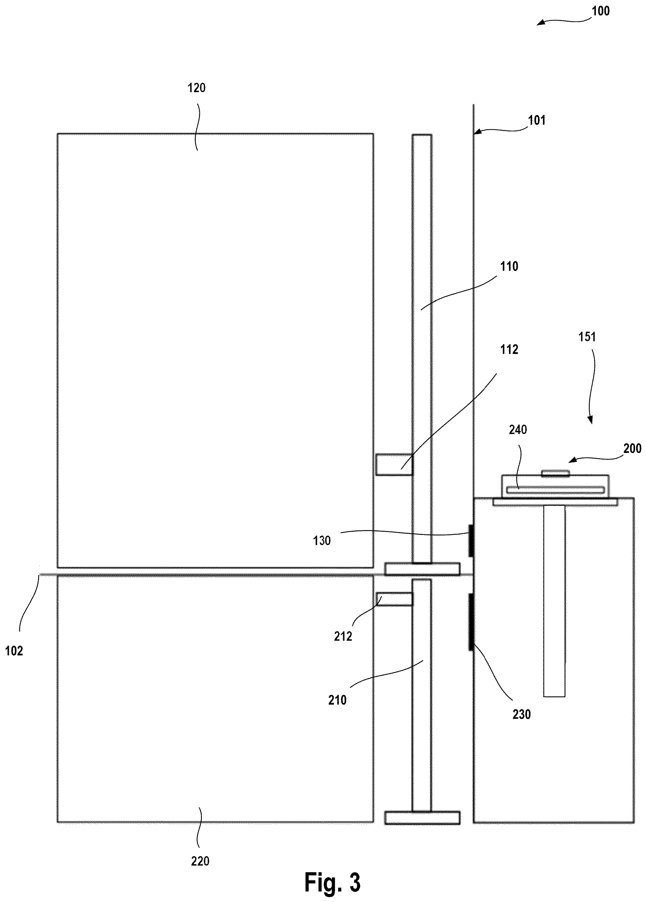

In Figure 1 an embodiment of a semiconductor fabrication tool in the form of a stocker according to the present invention is schematically depicted in a top view and collectively referred to with reference numeral 100. In Figures 2 and 3, the stocker 100 is shown in side views.

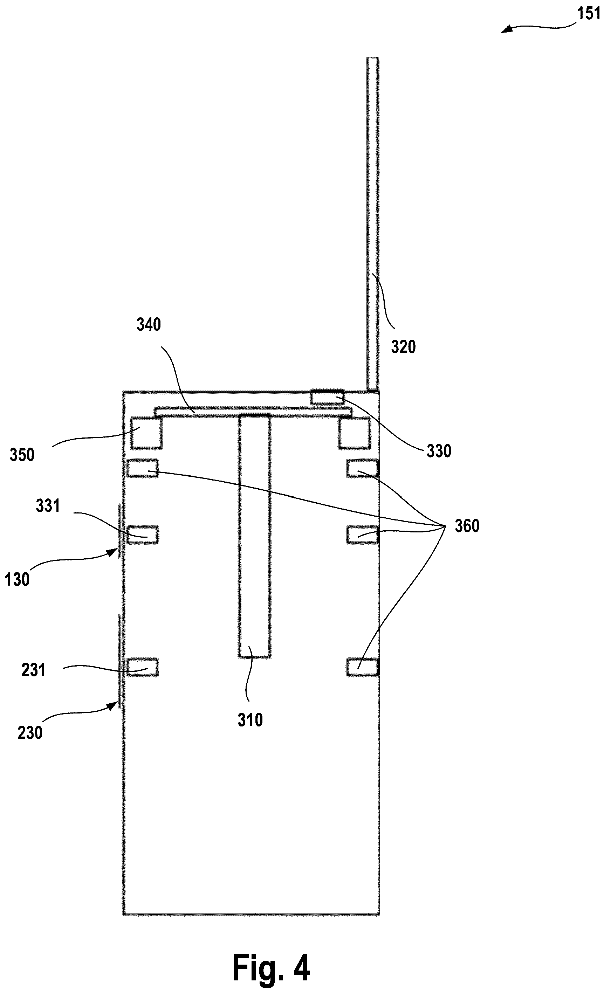

Stocker 100, in the example shown, comprises an article processing unit, in this case a motorized article storage unit, here configured as a storage carousel 120, which, in the example shown, comprises six axially stacked storage portions 121, 122, 123, 124, 125, 126, each of which are configured to hold a predefined number of semiconductor fabrication articles, for example reticles, in a corresponding number of storage positions arranged around a circumference of the storage carousel 120. Each of the axial storage portions 121, 122, 123, 124, 125, 126 is rotatable about a common rotation axis 129 by a respective dedicated motor 131, 132, 133, 134, 135, 136. The motors may be arranged in a circumferential position in relation to the storage carousel or in a position on the rotation axis 129. During operation of the stocker, when an article, such as a reticle, is to be stored within one of the storage positions in the stocker 100, the respective article is received from a periphery of the stocker 100 via a load port 151, 152, 153, 154. The load port (hereinafter also referred to with only the reference numeral 151) is depicted in greater detail in Figure 4. Generally, any of the load ports 151, 152, 153, 154 may be used for loading an article into or out of the stocker 100. It is to be noted, however, that it is preferred to use a load port associated with an article handler 112, 114 that is not performing any handling operation at the time of request or that is further advanced with a previously requested handling operation.

As already mentioned at the outset, the stocker according to this embodiment of the invention is configured to store articles such as reticles without their respective transport container, i.e. in a bare state or in storage encasements. Inner pods 240 forming part of a conventional transport container 200 as described at the beginning of this description (double pod) may be used as such a storage encasement. In other words, the outer pod needs to be removed before storing the article and needs to be reassembled around the inner pod 240 before providing the article to an outer interface of the stocker. Separating outer pods from the stored articles results in a cleaner storage environment and in a drastically reduced spatial footprint, i.e. higher storage density. In other embodiments, the articles may be provided in a simple transport container 200 such as an RSP150 or RSP200, i.e. not a double pod. This may particularly be the case with articles used in lower resolution processes such as DUV-lithography. In other words, the article to be stored may be a bare article 240 or an article within an inner encasement 240. This inner encasement may also be a dedicated storage encasement, i.e. different from a conventional inner pod.

As shown in Fig. 3, a separate container storage unit 220 may be provided to store or buffer a number of outer pods. This storage 220 unit is separated from the article storage unit 120 by an internal wall 102 in order to prevent cross contamination from the outer pods to the stored articles. However, this internal wall is not necessarily present in all embodiments of a tool according to the invention. For example, a (particularly laminar) purge gas flow in a vertical direction may be sufficient to prevent said cross contamination.

The load port 151, therefore, has two separate internal interfaces 130 and 230 at an outer wall 101 of the tool 100 for transferring articles (in this case with inner pods 240 as a storage encasement) to the article storage unit 120 and outer pods or double pods (herein also referred to as "transport containers") 200 to the container storage unit 220, respectively. The container storage unit 220 is associated with at least one container handler 212, which is configured to transfer a transport container 200 (with or without an article contained therein) between the load port 151 and the container storage unit 220. In the example shown, the container handler 212 moves along the vertical rail 210, in a way corresponding to the operation mode of the article handlers 112, 114 described herein above. The container storage unit 220 may be constructed in a similar way as the article storage unit 120, for example in the form of a storage carousel.

Since the articles to be stored need to be retrieved from the transport containers 200 prior to storage, the load port 151 is configured to open the transport container 200 and to provide access to the inner volume of the transport container 200 for the article handler 112, 114 to retrieve an article therefrom or to place an article therein.

In the example shown, the load port is configured to accept a transport container 200 on a platform 340, i.e. from above. A presence sensor 330 and/or a light curtain 320 may provided to detect the presence of a transport container 200 and/or of other objects at this external interface of the load port in order to provide for safe operation. For example, in case of a detected presence of objects other than transport containers, operation of the respective load port 151 may be blocked. The presence sensor 330 may also be configured to identify the respective transport container 200, e.g. with RFID technology and/or an optical identification technique, such as bar code or QR code reading.

In an operation for transferring a transport container 200 received at the external interface into the tool 100, the platform 340 descends into the load port along a vertical rail 310. During this descent, a purging may be effected, for example by flowing a purge gas across the outer surface of the transport container 200 and/or by evacuating a volume surrounding the transport container 200.

An opener 350 is provided to open the transport container, for example by unlocking a locking mechanism of the outer pod and then holding a lid of the outer pod in place, while the platform 340, on which the bottom part of the outer pod rests, further descends along rail 310. The descent of the platform (and its load) may be monitored by position sensors 360.

When the platform 340 reaches a height corresponding to the article transfer interface 130 (i.e. the first internal interface 130), the article handler 112, 114 may access the load port via this first internal interface 130 to retrieve the article (e.g. together with the inner pod 240) and to transfer the article into the article storage unit 120. This access operation may be monitored by a first interface sensor 331. The first internal interface 130 may comprise a shutter in order to minimize contamination of the inner volume of the article storage unit 120.

Depending on demand, the platform 340 may rise back up to collect the lid of the transport container 200, held by the container opener 350, which may then be transferred to the container interface 230 (i.e. the second internal interface 230) and picked up by the container handler 212 to be stored within the container storage unit 220. Similarly to the first internal interface 130, the second internal interface 230 is also equipped with a second interface sensor 231 configured to monitor a state of the second internal interface 230 and or operations performed at the second internal interface. Alternatively to proceeding to hand over the storage container 200 to the container handler 212 at the second internal interface 230, the platform 340 may wait at the first internal interface 130 for another article to be placed into the transport container 200 by the article handler 112, 114 via the first internal interface 130.

In times of high handling demand, the unloading of articles into the article storage unit 120 may be skipped and the transport container 200 may directly be stored with the article contained therein in the container storage unit 220, i.e. without the intermediate opening and transfer process. Once the handling demand decreases, these intermediately stored articles may be retrieved from the container storage unit into the load port 151, and then be transferred from the transport container 200 into the article storage unit 120 as described above.

In the example shown (c.f. Fig. 1), two load ports 151, 152 are associated with a first article handler 112 and two further load ports 153, 154 are associated with a second article handler 114. In the example shown, each of the article handlers 112, 114 is movably arranged on a respective vertical rail 110, which may, for example, comprise a gear rack for controlled vertical positioning of the respective article handler 112, 114. This configuration is, however, purely exemplary and any other conceivable way of controlling the vertical position of the article handlers 112, 114 may be used. The article handlers 112, 114 are configured to access their respective load ports 151, 152, 153, 154 to place an article therein and/or to remove an article therefrom. Further the article handlers 112, 114 are configured to access storage positions within the storage carousel 120 to place (i.e. store) an article therein and/or to retrieve an article therefrom. In order to access a specific storage position, the respective handler 112, 114 moves along the vertical rail 110 to the respective vertical location, in which the storage position is situated, and the storage carousel 120 rotates in order to move the respective storage position to a circumferential location accessible by the article handler. Particularly, only the axial storage portion, in which the respective storage position is located, is rotated by its respective motor, so that all the remaining storage portions remain accessible for the other one of the two article handlers 112, 114.

When storing an article within a storage position, the location of the storage position may be registered, for example in a central monitoring system of the semiconductor fabrication facility (not shown in the drawings), in order to easily retrace the article, when it is needed again. Alternatively, every article may have a unique storage position associated therewith, such that an article is always stored within the same storage position and no other article is stored within that specific storage position. If, at a later point in time, this article needs to be retrieved, the stocker 100 may be controlled to retrieve the article. In such a case, the respective storage position is identified, for example by retrieving an information about the location of the desired article from the mentioned central monitoring system. Then the article is retrieved by one of the article handlers, for example by article handler 112 in the manner described above. The retrieved article is then transferred to one of the load ports 151, 152 associated with the article handler 112 and processed (e.g. encased into a transport container) for transfer to the periphery of stocker 100.

Storing of an article within the stocker 100 comprises essentially the same steps as retrieving the article from the stocker, only in essentially reverse order: The article handler 112, 114 accesses the respective load port 151, 152, 153 or 154, in which the article to be stored is contained (being unloaded from any transportation container by the respective load port) to transfer the article from the load port into the stocker 100. The relevant storage position is moved to a circumferential location of the storage carousel 120 accessible by one of the article handlers 112, 114, the respective article handler 112, 114 (carrying the article) is moved to the right axial (i.e. vertical) location, and accesses the storage position for storing the article therein. Finally, the article handler is retracted from the storage position. At this point in time, the article handler used is ready for the next handling operation, i.e. storing or retrieving of (another) article.

In the example shown, each of the axial storage portions 121, 122, 123, 124, 125, 126 is mechanically couplable with its respective neighbouring storage portion by a coupler 140. For example, axial storage portion 123 is mechanically couplable with axial storage portion 122 and/or storage portion 124, respectively. Therefore, for example in the event of a motor failure, each of the axial storage portions may be coupled with one of its neighbouring storage portions in order to be rotated by the respective motor of the neighbouring storage portion. In such a case, the respective failed motor may be decoupled from the respective storage portion and/or the rotational axis 129 in order to prevent interference with a rotation effected by the motor of the respective neighbouring storage portion. In some embodiments, this may not be necessary, for example when using motors that do not prevent free rotation in idle mode. The coupler 140 may, for example, be provided in the form of a movable bolt on one or both of the two neighbouring axial storage portions with a corresponding recess for accepting the bolt in case a coupling is desired. Other methods of coupling may also be used, for example, magnetic coupling using a (e.g. retractable or rotatable) permanent magnet or a switchable electromagnet with a respective (e.g. ferromagnetic) counterpart on the respective neighbouring storage portion. The coupler may be arranged in one or more circumferential positions and may couple the two neighbouring storage portions in predefined or arbitrary mutual rotatory positional relation.

In a case, in which more than one of the motors 131, 132, 133, 134, 135, 136 have failed, the corresponding storage portions may each be coupled to a neighbouring storage portion whose respective motor is still working or several mutually adjacent storage portions may be coupled together to the same storage portion with a working corresponding motor neighbouring at least one of the mutually adjacent storage portions. For example, if motors 135 and 136 are both not functional, both storage portions 125 and 126 may be coupled to each other and storage portion 125 may also be coupled to storage portion 124. In this case, motor 134 may rotate all three storage portions 124, 125 and 126 simultaneously. In another example, in which motors 134 and 135 are not functional, it may be more advantageous to couple storage portion 125 to storage portion 126 to be moved simultaneously by motor 136 and to couple storage portion 124 to storage portion 123 to be moved simultaneously by motor 133. This provides for larger parts of the storage carousel being moveable independently from one another. In at least one embodiment, it may be determined, which combination of storage portions leaves the maximum amount of occupied storage positions in an independently moveable state and to use the determined combination, in order to maximise throughput.

The foregoing description uses the example of a storage carousel 120 as the motorized storage unit. However, this configuration is not in all conceivable cases necessary for utilizing the present invention. Any other motorized or non- motorized storage unit can also be used instead of - or in addition to - the described storage carousel 120. One alternative example of a motorized storage unit configuration includes a (vertically or horizontally arranged) paternoster-type storage unit, but other motorized storage unit configurations are also useable in connection with this invention.

In the example shown in Fig. 3, the article storage unit 120 is positioned on top of the container storage unit 220, i.e. directly vertically adjacent. This enables the load port 151 to substantially only use one vertical axis of movement to connect the external interface with the first and second internal interfaces 130, 230. The internal interfaces 130, 230 are, therefore, substantially aligned vertically one above the other.

In some embodiments, at least two load ports (particularly those associated with the same article handler) may be vertically stacked one above the other.

The inner volume of the stocker 100 may be sealed against an atmosphere surrounding the stocker 100 and/or purged continuously or at intervals in order to minimize chemical and/or particulate contamination of the stored articles. Any conventionally used methods or devices to effect such sealing and/or purging functionality may be selected.

## Claims

1. Load port (151, 152, 153, 154) for interfacing an interior of a semiconductor fabrication tool, particularly a stocker, (100) for processing, particularly storing, a semiconductor fabrication article, particularly a reticle, with an exterior of the tool (100),
the load port (151, 152, 153, 154) comprising
an external interface configured to accept from and/or deliver to the exterior of the tool (100) a transport container (200) configured to hold at least one article,
a first internal interface (130) configured to allow access to an internal volume of the transport container (200) from the interior of the tool (100), and
a second internal interface (230) configured to accept from and/or deliver to the interior of the tool (100) the transport container (200),
wherein the load port (151, 152, 153, 154) is configured to open and/or close the transport container (200).

2. Semiconductor fabrication tool, particularly a stocker, (100) for processing a semiconductor fabrication article, particularly a reticle, the tool comprising at least one load port (151, 152, 153, 154) according to claim 1, an article handler (112, 114), and an article processing unit (120),
wherein the load port (151, 152, 153, 154) is configured to provide the article handler (112, 114) with access to the internal volume of the transport container (200) via the first internal interface (130),
wherein the article processing unit (120) is configured to process a predetermined number of articles, wherein processing an article particularly comprises storing the article in a respective storage position,
wherein the article handler (112, 114) is configured to retrieve an article from the article processing unit (120) and/or to retrieve the article from the opened transport container (200) and to transfer the article between the transport container (200) and the article processing unit (120),
the tool (100) further comprising a container handler (212) and a container storage unit (220),
wherein the container handler (212) is configured to transfer a transport container (200) between the load port (151, 152, 153, 154) and the container storage unit (220) via the second internal interface (230),
wherein the container storage unit (220) is configured to store a predetermined number of transport containers.

3. Tool (100) according to claim 2, wherein the article processing unit (120) and/or the container storage unit (220) comprises a motorized storage unit, particularly a rotatable storage carousel, with a plurality of storage positions.

4. Tool (100) according to claim 3, wherein the article handler comprises at least two article handlers (112, 114) each configured to access the storage positions within the article processing unit (120) and to place an article therein for storage or to retrieve an article therefrom, wherein the at least two article handlers (112, 114) are arranged at different positions with respect to the article processing unit (120) and are configured to access storage positions within the article processing unit (120) substantially independently of one another.

5. Tool (100) according to claim 3 or 4, wherein the container handler (212) comprises at least two container handlers (212) each configured to access the storage positions within the container storage unit (220) and to place a transport container (200) therein for storage or to retrieve a transport container (200) therefrom, wherein the at least two container handlers (212) are arranged at different positions with respect to the container storage unit (220) and are configured to access storage positions within the container storage unit (220) substantially independently of one another.

6. Tool (100) according to any one of claims 3, 4 or 5, wherein the motorized storage unit (120, 220) comprises at least two, three, four, five or more storage portions (121, 122, 123, 124, 125, 126), wherein each one of the storage portions (121, 122, 123, 124, 125, 126) comprises a motor (131, 132, 133, 134,
135, 136) configured to displace the respective storage portion (121, 122, 123, 124, 125, 126) substantially independently of any of the remaining storage portions (121, 122, 123, 124, 125, 126).

7. Tool (100) according to claim 6, wherein neighbouring storage portions (121, 122, 123, 124, 125, 126) are mechanically couplable (140) such that two or more coupled storage portions can be simultaneously displaced by means of the motor (131, 132, 133, 134, 135, 136) of one of the coupled storage portions (121, 122, 123, 124, 125, 126).

8. Tool (100) according to any one of claims 2 to 7, wherein each of the storage positions of the article processing unit (120) is configured to hold exactly one article, particularly without any encasement or carrier.

9. Tool (100) according to any one of claims 2 to 8, wherein the article processing unit (120) and the container storage unit (220) are positioned vertically directly adjacent to one another.

10. Method of operating a semiconductor fabrication tool, particularly a stocker, (100) according to any one of claims 2 to 9, comprising
accepting, at the external interface of the load port (151, 152, 153, 154), a transport container (200),
controlling the load port (151, 152, 153, 154) to open the transport container (200) and to provide the at least one article handler (112, 114) with access to the internal volume of the transport container (200) via the first internal interface (130),
controlling the article handler (112, 114) to retrieve an article from the transport container (200) and/or to place an article into the transport container (200), and
controlling the load port (151, 152, 153, 154) to close the transport container (200).

11. Method according to claim 10, wherein the tool (100) is configured at least according to claim 3, the method comprising controlling the motorized storage unit (120) to move the storage position within a reach of the article handler (112, 114).

12. Method according to claim 10 or 11, wherein the tool (100) is configured at least according to claim 4, the method comprising controlling a first one (112) of the at least two article handlers (112, 114) to perform a first handling operation regarding a first article, the first handling operation comprising accessing a first storage position of the plurality of storage positions within the article processing unit (120) of the tool (100) and controlling a second one (114) of the at least two article handlers (112, 114) to perform a second handling operation regarding a second article, the second handling operation comprising accessing a second storage position of the plurality of storage positions within the article processing unit (120).

13. Method according to claim 12, wherein the second handling operation is performed during a time in which the first article handler (112) is performing at least a part of the first handling operation, wherein the second storage position is different from the first storage position.

14. Method of operating a tool (100) for storing a semiconductor fabrication article, the tool comprising an article processing unit (120) comprising a motorized storage unit with a plurality of storage positions and at least one article handler (112, 114), particularly a method according to any one of claims 10 to 13, wherein the motorized storage unit (120) comprises at least two, three, four, five or more storage portions (121, 122, 123, 124, 125, 126), wherein each one of the storage portions (121, 122, 123, 124, 125, 126) is displaceable independently of any of the remaining storage portions (121, 122, 123, 124, 125, 126) by a respective motor (131, 132, 133, 134, 135, 136), the method comprising
controlling the at least one article handler (112, 114) to perform a first handling operation regarding a first article, the first handling operation comprising accessing a first storage position of the plurality of storage positions within the motorized storage unit (120) of the tool (100) and controlling the at least one article handler (112, 114) to perform a second handling operation regarding a second article, the second handling operation comprising accessing a second storage position of the plurality of storage positions within the motorized storage unit (120),
identifying the storage portions (121, 122, 123, 124, 125, 126) in which the first and second storage positions are located, respectively;
controlling the respective motor (131, 132, 133, 134, 135, 136) of the identified storage portions to move the first and second storage positions within the reach of the at least one article handler (112, 114), respectively;
determining if the displacement of the identified storage portions was effected as controlled, and, in case at least one storage portion was not displaced as controlled;
coupling the respective storage portion with a neighbouring storage portion and controlling the motor of the neighbouring storage portion to move the first or second storage position within the reach of the at least one article handler (112, 114).
